(19) Europäisches Patentamt
European Patent Office
Office européen des brevets

(11) EP 4 714 586 A1

(12) **EUROPEAN PATENT APPLICATION**

(43) Date of publication:
25.03.2026 Bulletin 2026/13

(21) Application number: 25197125.5

(22) Date of filing: 20.08.2025

(51) International Patent Classification (IPC):
*B23K 35/26* (2006.01)      *B23K 35/02* (2006.01)
*B23K 35/362* (2006.01)     *C22C 13/00* (2006.01)
*C22C 13/02* (2006.01)      *H05K 3/3465* (2026.01)
*H05K 3/3489* (2026.01)     *B23K 1/00* (2006.01)

(52) Cooperative Patent Classification (CPC):
B23K 35/262; B23K 1/0016; B23K 35/0244;
B23K 35/025; B23K 35/362; C22C 13/00;
C22C 13/02; H05K 3/3465; H05K 3/3489

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 10.09.2024 JP 2024157013

(71) Applicant: Tamura Corporation
Tokyo 178-8511 (JP)

(72) Inventor: ARAI, Masaya
Iruma-shi, Saitama 358-0032 (JP)

(74) Representative: Cabinet Beau de Loménie
103, rue de Grenelle / CS 90800
75340 Paris Cedex 07 (FR)

(54) **SOLDER ALLOY, SOLDER PASTE, PRINTED CIRCUIT BOARD, AND ELECTRONIC CONTROL DEVICE**

(57) A solder alloy comprising Ag, Cu, Bi, Ni, and Co, with the balance being Sn, in which a Ag content is 2.5 mass% or more and 4.0 mass% or less, a Cu content is 0.6 mass% or more and 0.75 mass% or less, a Bi content is 2.0 mass% or more and 4.5 mass% or less, a Ni content is 0.01 mass% or more, a Co content is 0.01 mass% or more, a total content of Ni and Co is 0.05 mass% or less, and
the solder alloy satisfies the following formula (1):

$$13 \leq 58.046 + (-4.238 \times Ag) + (-11.371 \times Cu) + (-4.145 \times Bi) \leq 33 \tag{1}$$

where the element symbol in the above formula (1) represents a content (mass%) of each element in the solder alloy.

Fig.2

EP 4 714 586 A1

## Description

Technical Field

The present invention relates to a solder alloy, a solder paste, a printed circuit board, and an electronic control device.

Background Art

Solder alloys are one of joining materials used for joining target materials (for example, a printed wiring board and an electronic component). One of the characteristics required for the solder alloy is resistance to fatigue fracture (thermal fatigue resistance) of a joint portion occurring under an environment where a temperature difference is significantly large (for example: -30°C to 115°C, -40°C to 125°C) such as engine compartments of automobiles.

As a solder alloy or a solder paste having the above thermal fatigue resistance, for example, provided are an on-vehicle solder comprising : Ag: 2.8 to 4 mass%; Bi: 1.5 to 6 mass%; Cu: 0.8 to 1.2 mass%; at least one selected from the group consisting of Ni, Fe and Co in a total amount of 0.005 to 0.05 mass%; and a balance being Sn (Patent Literature 1); a tin-silver-copper solder alloy comprising tin, silver, copper, bismuth, nickel, and cobalt, wherein relative to the total amount of the solder alloy, the silver content is 2 mass% or more and 4 mass% or less, the copper content is 0.1 mass% or more and 1 mass% or less, the bismuth content is 0.5 mass% or more and 4.8 mass% or less, the nickel content is 0.01 mass% or more and 0.15 mass% or less, the cobalt content is 0.001 mass% or more and 0.008 mass% or less, and the tin content is the remaining content (Patent Literature 2); and a solder paste composition comprising a solder alloy and a flux, wherein the solder alloy comprises 2 mass% or more and 4 mass% or less of Ag, 1 mass% or less of Cu, and more than 1.5 mass% and 3 mass% or less of Bi, with the balance being substantially Sn, the flux comprise a synthetic resin, a thixotropic agent, an activator, and a solvent, and a flux residue formed by the flux has an adhesive force of 0.2 N/mm$^2$ or more after 2000 cycles of a thermal shock test with one cycle consisting of -40°C/30 min to 125°C/30 min (Patent Literature 3).

Patent Literature 1: JP 5024380 B
Patent Literature 2 : JP 5349703 B
Patent Literature 3 : JP 2016-26879 A

SUMMARY OF INVENTION

Technical Problem

One of the causes of the fatigue fracture described above is the plastic deformation of the joint portion, which is caused by stress repeatedly generated in the joint portion due to a temperature difference. Therefore, the solder alloys disclosed in Patent Literatures 1 to 3 comprises predetermined alloy elements to thereby strengthen the joint portion through solid solution strengthening, precipitation strengthening, or the like, thus preventing plastic deformation of the joint portion.

However, when a strong external force due to falling or the like (hereinafter, referred to as "impact force") is momentarily applied to the joint portion where dislocations are difficult to move due to solid solution strengthening or the like, the joint portion may be damaged since it is not able to absorb the impact energy generated by the action of the impact force. Therefore, in order to form a joint portion having resistance to the impact force (hereinafter, referred to as "impact resistance"), it is desirable to improve the toughness of the solder, that is, to form a solder alloy in which dislocations easily slip. However, the solder in which dislocations easily slip is a solder alloy which is easily plastically deformed. It can be seen that the thermal fatigue resistance and the impact resistance are in a trade-off relationship. In addition, many situations are assumed in which an impact force is applied to a joint portion even in an environment with a large temperature difference. It is therefore required to provide a solder alloy that can achieve both of these characteristics.

As described above, a main object of the present invention is to provide a solder alloy, a solder paste, a printed circuit board, and an electronic control device that can achieve both thermal fatigue resistance and impact resistance.

Solution to problem

(1) A solder alloy according to an aspect of the present invention comprises Ag, Cu, Bi, Ni, and Co, with the balance being Sn, wherein the Ag content is 2.5 mass% or more and 4.0 mass% or less, the Cu content is 0.6 mass% or more and 0.75 mass% or less, the Bi content is 2.0 mass% or more and 4.5 mass% or less, the Ni content is 0.01 mass% or more, the Co content is 0.01 mass% or more, a total content of Ni and Co is 0.05 mass% or less, and the solder alloy satisfies the following formula (1):

$$13 \leq 58.046 + (-4.238 \times Ag) + (-11.371 \times Cu) + (-4.145 \times Bi) \leq 33 \tag{1}$$

where the element symbol in the above formula (1) represents a content (mass%) of each element in the solder alloy.

(2) In the composition according to the above (1), the Bi content is preferably 2.0 mass% or more and 4.0 mass% or less.

(3) In the composition according to the above (1), the Bi content is preferably 2.0 mass% or more and 3.5 mass% or less.

(4) In the composition according to any one of the above (1) to (3), the solder alloy according to an aspect of the present invention preferably further comprises 0.01 mass% or more and 0.05 mass% or less of Fe.

(5) In the composition according the above (4), the Fe content is preferably 0.01 mass% or more and 0.04 mass% or less.

(6) In the composition according to any one of the above (1) to (5), the solder alloy according to an aspect of the present invention preferably has a Charpy impact value of 15 J/cm$^2$ or more as measured at 25°C using a U-notch according to a test method specified in JIS Z2242.

(7) A joining material according to an aspect of the present invention comprises the solder alloy according to any one of the above (1) to (6).

(8) A solder paste according to an aspect of the present invention comprises a powder of the solder alloy according to any one of the above (1) to (6) and a flux comprising a base resin, a thixotropic agent, an activator, and a solvent.

(9) A printed circuit board according to an aspect of the present invention comprises a joint portion comprising the solder alloy according to any one of the above (1) to (6).

(10) A printed circuit board according to an aspect of the present invention comprises a joint portion comprising the solder paste according to the above (8).

(11) An electronic control device according to an aspect of the present invention comprises the printed circuit board according to the above (9) or (10).

Advantageous effect of the invention

The solder alloy according to an aspect of the present invention can achieve both thermal fatigue resistance and impact resistance. When the solder paste according to an aspect of the present invention comprises the above solder alloy, both thermal fatigue resistance and impact resistance can be achieved.

The solder alloy and solder paste of the present invention can provide a printed circuit board and an electronic control device that have a joint portion capable of achieving both thermal fatigue resistance and impact resistance.

BRIEF DESCRIPTION OF DRAWINGS

FIG. 1 is a schematic cross-sectional view of a printed circuit board having a joint portion having a fillet portion that covers the side surface of an electronic component and has a gently flared shape; and

FIG. 2 is a schematic cross-sectional view of a printed circuit board having a joint portion having a fillet portion with a large inclination in which a portion covering the side surface of an electronic component is reduced.

Description of Embodiments

Hereinafter, embodiments of the present invention will be described. Note that the present invention is not limited to the following embodiments.

(1) Solder alloy

Ag contributes mainly to the strength of the solder alloy by precipitation and dispersion of fine Ag$_3$Sn. When the solder alloy of the present embodiment comprises 2.5 mass% or more and 4.0 mass% or less of Ag, the solder alloy can maintain good toughness while having high strength. The Ag content is preferably 2.5 mass% or more and 4.0 mass% or less, and more preferably 2.8 mass% or more and 3.8 mass% or less.

Cu contributes mainly to the strength of the solder alloy by precipitation and dispersion of Cu$_6$Sn$_5$. When the solder alloy of the present embodiment comprises 0.6 mass% or more and 0.75 mass% or less of Cu, the solder alloy has high strength. In addition, the solder alloy can suppress concentration of $Cu_6Sn_5$ at the interface between the joint portion and the joining target material.

Bi enables solid solution strengthening of the solder alloy by substituting a part of the crystal lattice of Sn. When the solder alloy of the present embodiment comprises 2.0 mass% or more and 4.5 mass% or less of Bi, the solder alloy can maintain good toughness while having high strength due to solid solution strengthening. When the Bi content is 2.0 mass% or more and 4.0 mass% or less, a solder alloy having more excellent thermal fatigue resistance can be provided. When the Bi content is 2.0 mass% or more and 3.5 mass% or less, a solder alloy having good thermal fatigue resistance and further excellent impact resistance can be provided.

Ni and Co contribute mainly to the strength of the solder alloy by precipitation and dispersion of fine $(Cu,Ni,Co)_6Sn_5$. When the solder alloy of the present embodiment comprises 0.01 mass% or more of Ni and further comprises 0.01 mass% or more of Co, the solder alloy has high strength. The solder alloy enables precipitation of $(Cu,Ni,Co)_6Sn_5$ at the interface between the joint portion and the joining target material, and thus can prevent the growth of the $Cu_3Sn$ layer in the vicinity of the interface.

When the solder alloy of the present embodiment comprises 0.05 mass% or less of Ni and Co in total amount, the generation of needle-shaped substance composed of Sn, Cu, Ni, and Co in the solder ingot can be suppressed. As a result, the solder alloy can prevent precipitation of needle-shaped substance when the solder alloy is formed into a powder, and thus can prevent deterioration of the release property of the solder paste comprising the solder alloy.

In the solder alloy of the present embodiment, each content (mass%) of Ag, Cu, and Bi satisfies the following formula:

$$13 \le 58.046 + (-4.238 \times Ag) + (-11.371 \times Cu) + (-4.145 \times Bi) \le 33 \qquad (1)$$

Wherein the element symbol in the above formula (1) represents a content (mass%) of each element in the solder alloy.

The solder alloy of the present embodiment having the above composition can achieve both thermal fatigue resistance and impact resistance, which are normally in a trade-off relationship, by the composition of the solder alloy and by the structure of the joint portion formed with the solder alloy (examples: type of intermetallic compounds ($Ag_3Sn$, $Cu_6Sn_5$, $(Cu,Ni,Co)_6Sn_5$, and the like), as well as grain size, amount, distribution, and the like of these intermetallic compounds, of the crystal lattice of Sn in which a part is substituted with Bi, and of other crystals).

That is, the types and contents of the alloy elements constituting the solder alloy affect the characteristics of the solder alloy and the joint portion. Therefore, even if a certain characteristic can be improved by reducing the content of a specific alloy element of a certain solder alloy, deterioration of another characteristic generally occurs. On the other hand, the solder alloy of the present embodiment configured as described above can achieve both of characteristics that are normally in a trade-off relationship.

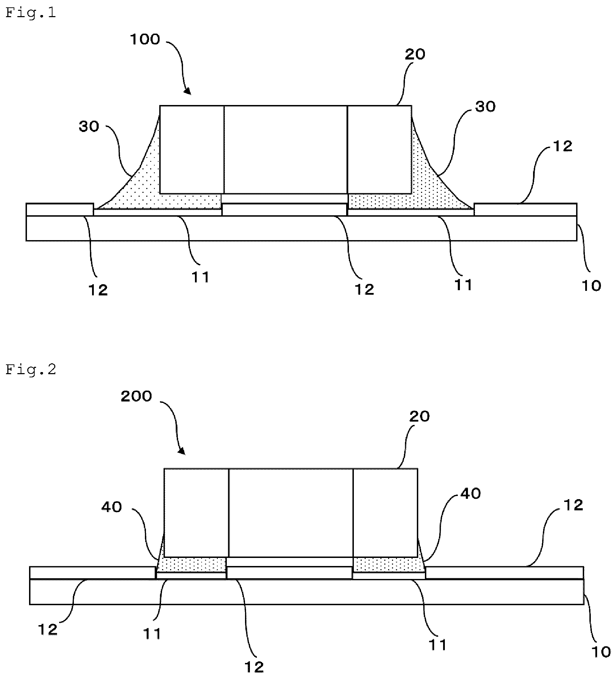

Conventionally, a method of joining target materials at a joint portion (joint portion 30) having a fillet portion that covers the side surface of an electronic component and has a gently flared shape as illustrated in FIG. 1 has been common. On the other hand, in recent years, a method of joining target materials at a joint portion (joint portion 40) having a fillet portion with a large inclination (small volume) in which a portion covering the side surface of an electronic component is reduced, as illustrated in FIG. 2 or a joint portion having no portion covering the side surface of an electronic component (having no fillet portion) has been adopted.

As the volume of the fillet portion decreases, the strength of the joint portion decreases. Therefore, fatigue fracture caused by a temperature difference is more likely to occur in a joint portion having a fillet portion with a small volume than in a joint portion having a fillet portion with a large volume.

However, the solder alloy of the present embodiment configured as described above can exhibit good thermal fatigue resistance even at a joint portion where such fatigue fracture is likely to occur. Furthermore, the solder alloy can achieve high impact resistance while having such more excellent thermal fatigue resistance, in other words, more excellent strength.

The solder alloy of the present embodiment may further optionally comprise Fe. In case that the solder alloy comprises Fe, when the Fe content is 0.01 mass% or more and 0.05 mass% or less, Sn crystals are refined. As a result, the solder alloy can exhibit more excellent thermal fatigue resistance while having high impact resistance. When the Fe content is 0.01 mass% or more and 0.04 mass% or less, the thermal fatigue resistance can be further enhanced.

The balance of the solder alloy of the present embodiment is Sn. The solder alloy of the present embodiment may comprise elements other than the above alloy elements as inevitable impurities.

In the solder alloy of the present embodiment, among the above composition, a Charpy impact value as measured at 25°C using a U-notch according to a test method specified in JIS Z2242:2023 is preferably 15 $J/cm^2$ or more.

The solder alloy of the present embodiment can be used for joining materials such as a solder paste, a solder ball, a wire, a solder preform, and a flux cored solder described later. The form of the joining material can be appropriately selected according to the size, type, and use of the joining target material to be joined, a joining method, and the like. The solder alloy of the present embodiment may be used for any joining material as long as the joining material can form a joint portion.

(2) Solder paste

The solder paste of the present embodiment comprises the solder alloy of the present embodiment (hereinafter, referred to as "alloy powder") which is in the form of a powder, and is prepared, for example, by kneading the alloy powder and a flux to form a paste.

<Flux>

The flux can comprise, for example, a base resin, a thixotropic agent, an activator, and a solvent.

Examples of the base resin comprise a rosin-based resin; an acrylic resin obtained by polymerizing at least one monomer of acrylic acid, methacrylic acid, various esters of acrylic acid, various esters of methacrylic acid, crotonic acid, itaconic acid, maleic acid, maleic anhydride, esters of maleic acid, esters of maleic anhydride, acrylonitrile, methacrylonitrile, acrylamide, methacrylamide, vinyl chloride, or vinyl acetate; an epoxy resin; and a phenol resin. These can be used alone or in combination of two or more.

Examples of the thixotropic agent comprise hardened castor oil, hydrogenated castor oil, bisamide-based thixotropic agents (saturated fatty acid bisamide, unsaturated fatty acid bisamide, aromatic bisamide, and the like), oxyfatty acids, and dimethyldibenzylidene sorbitol and the like. These can be used alone or in combination of two or more.

Examples of the activator comprise organic acids (monocarboxylic acids, dicarboxylic acids, and other organic acids), halogen-containing compounds, and amine-based activators. These can be used alone or in combination of two or more.

Examples of the solvent comprise alcohol-based solvents, butyl cellosolve-based solvents, glycol ether-based solvents, and ester-based solvents and the like. These can be used alone or in combination of two or more.

The flux may comprise an antioxidant. Examples of the antioxidant comprise hindered phenol-based antioxidants, phenol-based antioxidants, bisphenol-based antioxidants, and polymer-type antioxidants and the like. An additive such as a matting agent or an antifoaming agent and the like may be further added to the flux.

When the solder paste of the present embodiment is prepared, the blend ratio (mass%) of the alloy powder to the flux can be 65 : 35 to 95 : 5. The blend ratio may be, for example, 85 : 15 to 93 : 7 or 87 : 13 to 92 : 8. However, the blend ratio (mass%) of the alloy powder to the flux is not limited thereto, and can be appropriately changed.

The particle size of the alloy powder may be 1 $\mu$m or more and 40 $\mu$m or less. The particle size may be 5 $\mu$m or more and 35 $\mu$m or less, or 10 $\mu$m or more and 30 $\mu$m or less. However, the particle size of the alloy powder is not limited thereto, and can be appropriately changed.

When the solder paste of the present embodiment comprises the alloy powder, both thermal fatigue resistance and impact resistance can be achieved.

(3) Joint portion

The joint portion of the present embodiment (hereinafter, referred to as "present joint portion") is formed using the solder alloy of the present embodiment (hereinafter, referred to as "present solder alloy") and the above joining material (hereinafter, including a solder paste unless otherwise specified), and joins the joining target materials to each other. The method for forming the present joint portion may be any method as long as the joint portion can be formed using the present solder alloy or the above joining material, and any method such as a reflow method or a flow method can be adopted. In addition, the form of the joining material to be used can also be appropriately selected according to the size, type, and use of the joining target material to be joined, the method of forming the joint portion, and the like.

(4) Printed circuit board and electronic control device

A printed circuit board of the present embodiment (hereinafter, referred to as "present printed circuit board") has the present joint portion. The present printed circuit board is prepared, for example, by printing the solder paste described above at a predetermined position on a printed wiring board, placing an electronic component at the predetermined position, and then reflowing the printed wiring board at 220°C to 250°C. By this reflow, a joint portion for electrically joining the electrode and the electronic component is formed on the printed circuit board.

In the present printed circuit board, as illustrated in FIGS. 1 and 2, an electronic component 20 may be mounted on a printed wiring board 10 equipped with electrodes 11 and insulating layers 12, and the electronic component 20 and the printed wiring board 10 may be electrically joined by joint portions 30 or 40. The present printed circuit board may have no fillet portion, that is, may have a joint portion having no portion covering the side surface of the electronic component.

As described above, the present solder alloy can achieve both thermal fatigue resistance and impact resistance, which are normally in a trade-off relationship. Therefore, the present printed circuit board having the present joint portion formed using the present solder alloy can be suitably used for electronic control devices placed in a severe environment where higher reliability is required.

The electronic control device of the present embodiment controls the operation of the components constituting the electronic device. As described above, the electronic control device including the present printed circuit board can exhibit high reliability.

[Examples]

Hereinafter, the present invention will be described in detail with reference to Examples and Comparative Examples. Note that the present invention is not limited to these Examples.

<Preparation of flux>

The following components were kneaded to obtain fluxes according to Examples and Comparative Examples.

Hydrogenated acid-modified rosin (product name: KE-604, manufactured by Arakawa Chemical Industries, Ltd.) 51 mass%

Hardened castor oil 6 mass%
Dodecanedioic acid 10 mass%
Malonic acid 1 mass%
Diphenylguanidine hydrobromide 2 mass%
Hindered phenol-based antioxidant (product name: Irganox 245, manufactured by BASF Japan Ltd.) 1 mass%
Diethylene glycol monohexyl ether 29 mass%

Preparation of solder paste

11 mass% of the flux and 89 mass% of a powder (particle size: 20 μm to 38 μm) of each solder alloy described in Tables 1 and 2 were mixed to prepare solder pastes according to Examples and Comparative Examples.

[Table 1]

| | mass% | | | | | | |
|---|---|---|---|---|---|---|---|
| | Sn | Ag | Cu | Bi | Ni | Co | Fe |
| Example 1 | Balance | 3.2 | 0.65 | 2.0 | 0.04 | 0.01 | - |
| Example 2 | Balance | 3.2 | 0.65 | 3.0 | 0.04 | 0.01 | - |
| Example 3 | Balance | 3.2 | 0.65 | 3.5 | 0.04 | 0.01 | - |
| Example 4 | Balance | 3.2 | 0.65 | 4.0 | 0.04 | 0.01 | - |
| Example 5 | Balance | 3.2 | 0.65 | 4.5 | 0.04 | 0.01 | - |
| Example 6 | Balance | 2.5 | 0.65 | 3.0 | 0.04 | 0.01 | - |
| Example 7 | Balance | 2.8 | 0.65 | 3.0 | 0.04 | 0.01 | - |
| Example 8 | Balance | 3.8 | 0.65 | 3.0 | 0.04 | 0.01 | - |
| Example 9 | Balance | 4.0 | 0.65 | 3.0 | 0.04 | 0.01 | - |
| Example 10 | Balance | 3.2 | 0.6 | 3.0 | 0.04 | 0.01 | - |
| Example 11 | Balance | 3.2 | 0.75 | 3.0 | 0.04 | 0.01 | - |
| Example 12 | Balance | 3.2 | 0.65 | 3.0 | 0.01 | 0.01 | - |
| Example 13 | Balance | 3.2 | 0.65 | 3.0 | 0.03 | 0.01 | - |
| Example 14 | Balance | 3.2 | 0.65 | 3.0 | 0.02 | 0.03 | - |
| Example 15 | Balance | 3.2 | 0.65 | 3.0 | 0.03 | 0.02 | - |
| Example 16 | Balance | 3.2 | 0.65 | 3.0 | 0.02 | 0.02 | - |

(continued)

|  | mass% | | | | | | |
|---|---|---|---|---|---|---|---|
|  | Sn | Ag | Cu | Bi | Ni | Co | Fe |
| Example 17 | Balance | 2.5 | 0.6 | 2.0 | 0.04 | 0.01 | - |
| Example 18 | Balance | 2.5 | 0.6 | 2.0 | 0.01 | 0.01 | - |
| Example 19 | Balance | 4.0 | 0.75 | 4.5 | 0.04 | 0.01 | - |
| Example 20 | Balance | 3.2 | 0.65 | 3.0 | 0.04 | 0.01 | 0.01 |
| Example 21 | Balance | 3.2 | 0.65 | 3.0 | 0.04 | 0.01 | 0.02 |
| Example 22 | Balance | 3.2 | 0.65 | 3.0 | 0.04 | 0.01 | 0.03 |
| Example 23 | Balance | 3.2 | 0.65 | 3.0 | 0.04 | 0.01 | 0.04 |
| Example 24 | Balance | 3.2 | 0.65 | 3.0 | 0.04 | 0.01 | 0.05 |

[Table 2]

|  | mass% | | | | | | |
|---|---|---|---|---|---|---|---|
|  | Sn | Ag | Cu | Bi | Ni | Co | Fe |
| Comparative Example 1 | Balance | 3.2 | 0.65 | 1.0 | 0.04 | 0.01 | - |
| Comparative Example 2 | Balance | 3.2 | 0.65 | 5.0 | 0.04 | 0.01 | - |
| Comparative Example 3 | Balance | 2.0 | 0.65 | 3.0 | 0.04 | 0.01 | - |
| Comparative Example 4 | Balance | 4.5 | 0.65 | 3.0 | 0.04 | 0.01 | - |
| Comparative Example 5 | Balance | 3.2 | 0.5 | 3.0 | 0.04 | 0.01 |  |
| Comparative Example 6 | Balance | 3.2 | 0.8 | 3.0 | 0.04 | 0.01 | - |
| Comparative Example 7 | Balance | 3.2 | 0.65 | 3.0 | - | 0.02 | - |
| Comparative Example 8 | Balance | 3.2 | 0.65 | 3.0 | 0.06 | 0.01 | - |
| Comparative Example 9 | Balance | 3.2 | 0.65 | 3.0 | 0.02 | - | - |
| Comparative Example 10 | Balance | 3.2 | 0.65 | 3.0 | 0.01 | 0.06 | - |
| Comparative Example 11 | Balance | 3.2 | 0.65 | 3.0 | 0.04 | 0.01 | 0.10 |
| Comparative Example 12 | Balance | 2.0 | 0.65 | 1.0 | 0.04 | 0.01 | - |
| Comparative Example 13 | Balance | 4.5 | 0.8 | 5.0 | 0.04 | 0.01 | - |

(1) Shear strength test

The following tools were prepared.

- Chip components (3.2 mm × 1.6 mm, Ni/Sn plated)
- A printed wiring board equipped with a solder resist having a pattern on which chip components of the above size can be mounted and with electrodes (1.6 mm × 0.55 mm) to which the chip components are to be connected
- A metal mask having the above pattern and a thickness of 150 μm

A test was performed for each solder paste according to the following procedure.
Each solder paste was printed on the printed wiring board using the above metal mask, and five chip components were placed on each solder paste.
Thereafter, the printed wiring board was heated using a reflow furnace (product name: TNP-538EM, manufactured by TAMURA Corporation) to prepare a printed circuit board including a joint portion (joint portion 40) having a shape as illustrated in FIG. 2. Reflow conditions at this time were set as follows: preheating was performed at 170°C to 190°C for 110 seconds, the peak temperature was 240°C, the time at 200°C or higher was 65 seconds, the time at 220°C or higher was 45 seconds, the cooling rate from the peak temperature to 200°C was 3°C to 8°C/sec, and the oxygen concentration was 1500 ±500 ppm. Two printed circuit boards were prepared.

Next, using a thermal shock tester (product name: ES-76LMS, manufactured by Hitachi Appliances, Inc.) with a set condition of -40°C (30 minutes) to 125°C (30 minutes), one of the printed circuit boards was exposed to an environment where a thermal shock cycle was repeated 1,000 cycles, and then taken out.

The shear strength of each of the chip component of the printed circuit board to which the thermal shock cycle was applied and of the printed circuit board to which the thermal shock cycle was not applied, was measured using an autograph (product name: EZ-L-500N, manufactured by Shimadzu Corporation).

The measurement conditions of the shear strength were in accordance with JIS C60068-2-21:2023. In the measurement of the shear strength, a shear jig having a flat end surface and a width equal to or larger than the dimension of the component was used, the shear jig was abutted against the side surface of the chip component, a force parallel to the printed circuit board was then applied at a predetermined shear rate, the maximum test force was obtained, and this value was taken as the shear strength. The shear height in the measurement was set to 1/4 or less of the height of the component, and the shear rate was set to 5 mm/min.

The average value of the shear strength of the printed circuit board to which the thermal shock cycle was not applied was defined as S0. The average value of the shear strength of the printed circuit board to which the thermal shock cycle was applied was defined as S1. The shear strength decrease rate was calculated based on the following calculation formula.

$$\text{Shear strength decrease rate} = (S0 - S1)/S0 \times 100$$

The calculated shear strength decrease rate was then evaluated according to the following criteria. The results are shown in Tables 3 and 4.

    o: Shear strength decrease rate is more than 10% and 20% or less
    ×: Shear strength decrease rate is more than 20%

(2) Shear strength test

Each printed circuit board was prepared under the same conditions as in the above (1) Shear strength test section, except for forming a joint portion (joint portion 30) having a shape as illustrated in FIG. 1, using a printed wiring board (two printed wiring boards for each solder paste) including a solder resist equipped with a pattern on which 3.2 mm × 1.6 mm chip components (Ni/Sn plated) can be mounted and with electrodes (1.6 mm×1.2 mm) to which the chip components are to be connected. The shear strength was measured to calculate the shear strength decrease rate. The calculated shear strength decrease rate was then evaluated according to the following criteria. The results are shown in Tables 3 and 4.

    ◎ Shear strength decrease rate is 10% or less
    o: Shear strength decrease rate is more than 10% and 20% or less
    ×: Shear strength decrease rate is more than 20%

(3) Crack resistance confirmation test

The following tools were prepared.

- A Quad Flat Non-leaded package (QFN) (0.5 mm pitch, 7 mm length × 7 mm width × 0.9 mm thickness, number of terminals: 44 pins)
- A glass epoxy substrate (a pattern on which the QFN can be mounted is, formed on a glass epoxy substrate surface-treated with Cu-OSP, thickness of 1.6 mm)
- A metal mask (corresponding to the above pattern, thickness of 150 µm)

A test was performed for each solder paste according to the following procedure.

First, a solder paste was printed on a glass epoxy substrate using a metal mask. Then, ten QFNs were placed at predetermined positions on the printed solder paste. The printing film thickness of the solder paste was adjusted by the above metal mask. Subsequently, the glass epoxy substrate on which the QFNs were placed was reflowed using a reflow furnace (product name: TNV30-508EM2-X, manufactured by TAMURA Corporation) to prepare a printed circuit board having the QFNs, the glass epoxy substrate, and a joint portion (having a shape like the joint portion 30 illustrated in FIG. 1) which joins the QFNs and the glass epoxy substrate. Two joint portions were formed for one QFN. The reflow was performed under the reflow conditions in which the preheating was performed at 170°C to 190°C for 110 seconds, the peak temperature was 240°C, the time at 220°C or higher was 45 seconds, and the cooling rate from the peak temperature to 200°C was 1°C to 8°C/sec. The oxygen concentration was set to 1,500 ±500 ppm.

Next, using a thermal shock tester (product name: ES-76LMS, manufactured by Hitachi Appliances, Inc.), the printed circuit board was exposed to an environment where the thermal shock cycle was repeated 1,000 cycles under a set condition of 1 cycle being from -40°C (30 minutes) to 125°C (30 minutes), to obtain a test substrate.

A target portion of the test substrate was cut out and sealed with an epoxy resin (product name: Epomount (main agent and curing agent), manufactured by Refinetech Co., Ltd.).

Then, the cross section of each joint portion that joins each QFN of the test substrate was made visible using a wet polishing machine (product name: TegraPol-25, manufactured by Marumoto Struers K.K.). The presence or absence of cracks in all joint portions (10 × 2 portions) of the test substrate and the state of the generated cracks were observed with a scanning electron microscope (product name: TM-1000, manufactured by Hitachi High-Tech Corporation).

From this observation result, the total sum of length of cracks and the total length of assumed line of cracks were calculated for each joint portion, and the crack rate (%) was obtained based on the following equation. Note that the total length of assumed line of cracks refers to the length of the course of a crack that completely breaks the joint portion (assumed line), assumed from the generated crack.

Crack rate (%) = (total sum of length of cracks)/(total length of assumed line of cracks) ×100

Then, the maximum value of the joint portion having the maximum value of the crack rate (%) was evaluated based on the following criteria. The results are shown in Tables 3 and 4.

◎: The maximum value of the crack rate is 15% or less.
o: The maximum value of the crack rate is more than 15% and 30% or less.
△: The maximum value of the crack rate is more than 30% and 50% or less.
×: The maximum value of the crack rate is more than 50%.

(4) Needle-shaped substance confirmation test

A solder ingot made of each solder alloy was prepared.

Then, a solder alloy powder was prepared using each solder ingot based on the following conditions.

First, 50 g of a solder ingot, 890 g of castor oil, and 10 g of hydrogenated acid-modified rosin (product name: KE-604, manufactured by Arakawa Chemical Industries, Ltd.) were placed in a 2 L stainless steel beaker. Then, this was continuously heated using a mantle heater. When the temperature of the contents in the stainless steel beaker reached 160°C, the stirring of the contents in the stainless steel beaker was started, using a homogenizer (manufactured by SMT Co., Ltd.) set at a rotation of 2,000 rpm. The heating with the mantle heater was continued during the stirring.

When the temperature of the contents in the stainless steel beaker reached 270°C, the heating was stopped and the rotation of the homogenizer was changed to 10,000 rpm. Then, the contents in the stainless steel beaker were stirred for 5 minutes. After completion of the stirring, the contents in the stainless steel beaker were cooled until the temperature reached room temperature.

Then, the solder alloy powder precipitated in castor oil was taken out from the stainless steel beaker, and was washed with ethyl acetate to remove attached substances. The state of the solder alloy powder was then observed with a digital microscope at a magnification of 200 times. The observation results were evaluated based on the following criteria. The results are shown in Tables 3 and 4.

∘ No needle-shaped substance is generated in solder alloy powder.
×: A needle-shaped substance was generated in the solder alloy powder.

(5) Charpy impact test

A test piece was prepared using each solder alloy in accordance with the conditions defined in JIS Z2242:2023, and a test was performed based on the following conditions.

Test piece: U-notch test piece
Test temperature: 25°C

Then, a value obtained by dividing the impact energy required for breaking each test piece by the cross-sectional area of the test piece was defined as the impact value. Each test piece was evaluated based on the following criteria. The results are shown in Tables 3 and 4.

◎: The impact value is 15.0 J/cm$^2$ or more.
○: The impact value is 12.5 J/cm$^2$ or more and less than 15.0 J/cm$^2$.
△: The impact value is 10.0 J/cm$^2$ or more and less than 12.5 J/cm$^2$.
×: The impact value is less than 10.0 J/cm$^2$.

[Table 3]

|  | (1) Shear strength test | (2) Shear strength test | (3) Crack resistance confirmation test | (4) Needle-shaped substance confirmation test | (5) Charpy impact test |
|---|---|---|---|---|---|
| Example 1 | ○ | ◎ | ○ | ○ | ◎ |
| Example 2 | ○ | ◎ | ○ | ○ | ◎ |
| Example 3 | ○ | ◎ | ○ | ○ | ◎ |
| Example 4 | ○ | ◎ | ○ | ○ | ○ |
| Example 5 | ○ | ○ | ○ | ○ | ○ |
| Example 6 | ○ | ○ | ○ | ○ | ◎ |
| Example 7 | ○ | ◎ | ○ | ○ | ◎ |
| Example 8 | ○ | ◎ | ○ | ○ | ◎ |
| Example 9 | ○ | ○ | ○ | ○ | ○ |
| Example 10 | ○ | ◎ | ○ | ○ | ◎ |
| Example 11 | ○ | ◎ | ○ | ○ | ◎ |
| Example 12 | ○ | ○ | △ | ○ | ◎ |
| Example 13 | ○ | ◎ | ○ | ○ | ◎ |
| Example 14 | ○ | ◎ | ○ | ○ | ◎ |
| Example 15 | ○ | ◎ | ○ | ○ | ◎ |
| Example 16 | ○ | ◎ | ○ | ○ | ◎ |
| Example 17 | ○ | △ | ○ | ○ | ◎ |
| Example 18 | ○ | △ | △ | ○ | ◎ |
| Example 19 | ○ | ○ | ○ | ○ | △ |
| Example 20 | ○ | ◎ | ◎ | ○ | ◎ |
| Example 21 | ○ | ◎ | ◎ | ○ | ◎ |
| Example 22 | ○ | ◎ | ◎ | ○ | ◎ |
| Example 23 | ○ | ◎ | ◎ | ○ | ◎ |
| Example 24 | ○ | ◎ | ○ | ○ | ◎ |

[Table 4]

|  | (1) Shear strength test | (2) Shear strength test | (3) Crack resistance confirmation test | (4) Needle-shaped substance confirmation test | (5) Charpy impact test |
|---|---|---|---|---|---|
| Comparative Example 1 | × | × | ○ | ○ | ◎ |
| Comparative Example 2 | ○ | ○ | ◎ | ○ | × |
| Comparative Example 3 | × | ○ | ○ | ○ | ◎ |
| Comparative Example 4 | × | × | ○ | ○ | ○ |

(continued)

| | (1) Shear strength test | (2) Shear strength test | (3) Crack resistance confirmation test | (4) Needle-shaped substance confirmation test | (5) Charpy impact test |
|---|---|---|---|---|---|
| Comparative Example 5 | × | ◎ | ○ | ○ | ○ |
| Comparative Example 6 | × | ○ | ○ | ○ | ○ |
| Comparative Example 7 | × | ○ | × | ○ | ○ |
| Comparative Example 8 | ○ | ◎ | ○ | × | ○ |
| Comparative Example 9 | × | ◎ | × | ○ | ○ |
| Comparative Example 10 | ○ | ◎ | ○ | × | ○ |
| Comparative Example 11 | × | × | × | ○ | ○ |
| Comparative Example 12 | × | × | Δ | ○ | ◎ |
| Comparative Example 13 | ○ | ○ | ◎ | ○ | × |

As described above, it can be seen that the solder alloys of Examples can achieve both thermal fatigue resistance and impact resistance, which are normally in a trade-off relationship. In addition, it can be seen that the solder alloys of Examples can exhibit good thermal fatigue resistance regardless of the shape of the joint portion, that is, even when the fillet portion has a gently flared shape while covering the side surface of the electronic component, or even when the fillet portion has a shape in which the portion covering the side surface of the electronic component is small and its inclination is large. In addition, despite having such high thermal fatigue resistance, the solder alloys of Examples can have good impact resistance, which is a trade-off characteristic.

In addition, the solder alloys of Examples can exhibit good thermal fatigue resistance even when an electronic component having no lead, such as QFN, that is, an electronic component in which stress generated due to a temperature difference is more likely to concentrate on a joint portion, is mounted.

Furthermore, it can be seen that the solder alloys of Examples can also suppress the generation of needle-shaped substances while exhibiting the above characteristics.

Therefore, the printed circuit board having such a joint portion is suitable for applications requiring high reliability. The printed circuit board can be suitably used, in an electronic control device that is required to have higher reliability, for example, those which are mounted in an engine room of an automobile.

100, 200 printed circuit board
10 printed wiring board
11 electrode joint portion 40
20 electronic component
joint portion 30, 40

**Claims**

1. A solder alloy comprising Ag, Cu, Bi, Ni, and Co, with the balance being Sn, wherein

the Ag content is 2.5 mass% or more and 4.0 mass% or less,
the Cu content is 0.6 mass% or more and 0.75 mass% or less,
the Bi content is 2.0 mass% or more and 4.5 mass% or less,
the Ni content is 0.01 mass% or more,
the Co content is 0.01 mass% or more,
the total content of Ni and Co is 0.05 mass% or less, and
the solder alloy satisfies the following formula (1):

$$13 \leq 58.046 + (-4.238 \times Ag) + (-11.371 \times Cu) + (-4.145 \times Bi) \leq 33 \tag{1}$$

where the element symbol in the formula (1) represents a content (mass%) of each element in the solder alloy.

2. The solder alloy according to claim 1, wherein the Bi content is 2.0 mass% or more and 4.0 mass% or less.

3. The solder alloy according to claim 1 or 2, wherein the Bi content is 2.0 mass% or more and 3.5 mass% or less.

4. The solder alloy according to any one of claims 1 to 3, further comprising 0.01 mass% or more and 0.05 mass% or less of Fe.

5. The solder alloy according to claim 4, wherein the Fe content is 0.01 mass% or more and 0.04 mass% or less.

6. The solder alloy according to any one of claims 1 to 5, wherein the solder alloy has a Charpy impact value of 15 J/cm$^2$ or more as measured at 25°C using a U-notch according to a test method specified in JIS Z2242.

7. A solder paste comprising:

   a powder of the solder alloy according to any one of claims 1 to 5; and
   a flux comprising a base resin, a thixotropic agent, an activator, and a solvent.

8. A printed circuit board comprising a joint portion comprising the solder alloy according to any one of claims 1 to 5.

9. An electronic control device comprising the printed circuit board according to claim 8.

Fig.1

Fig.2

Europäisches
Patentamt

European
Patent Office

Office européen
des brevets

# EUROPEAN SEARCH REPORT

Application Number

EP 25 19 7125

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/167705 A1 (TAMURA SEISAKUSHO KK [JP]) 6 September 2019 (2019-09-06) * claims 1-9 * * tables 1-4 * * paragraphs [0010] - [0077] * | 1-9 | INV.<br>B23K35/26<br>B23K35/02<br>B23K35/362<br>C22C13/00<br>C22C13/02<br>H05K3/3465<br>H05K3/3489<br>B23K1/00 |
| A | WO 2019/094242 A1 (ILLINOIS TOOL WORKS [US]) 16 May 2019 (2019-05-16) * claims 1-11 * * paragraphs [0005] - [0068] * * tables 1-5 * | 1-9 | |
| A | CN 112 475 664 A (SUZHOU EUNOW ELECTRONIC MATERIAL TECH CO LTD) 12 March 2021 (2021-03-12) * the whole document * | 1-9 | |
| A | EP 3 988 239 A1 (SENJU METAL INDUSTRY CO [JP]) 27 April 2022 (2022-04-27) * claims 1-30 * * tables 1-9 * * paragraphs [0012] - [0066] * | 1-9 | TECHNICAL FIELDS SEARCHED (IPC)<br><br>B23K<br>C22C<br>H05K |
| A | EP 3 040 152 A1 (SENJU METAL INDUSTRY CO [JP]) 6 July 2016 (2016-07-06) * claims 1-16 * * paragraphs [0014] - [0086] * * tables 1-5 * | 1-9 | |

The present search report has been drawn up for all claims

| Place of search | Date of completion of the search | Examiner |
|---|---|---|
| The Hague | 12 February 2026 | Vlassi, Eleni |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 25 19 7125

This annex lists the patent family members relating to the patent documents cited in  the above-mentioned European search report.
The members are as contained in the European Patent Office EDP file on
The European Patent Office is in no way liable for these particulars which are merely given for the purpose of information.

12-02-2026

| Patent document cited in search report | Publication date | Patent family member(s) | Publication date |
|---|---|---|---|
| WO 2019167705 A1 | 06-09-2019 | CN 111093889 A | 01-05-2020 |
| | | JP 6578393 B2 | 18-09-2019 |
| | | JP 2019147173 A | 05-09-2019 |
| | | KR 20200122980 A | 28-10-2020 |
| | | WO 2019167705 A1 | 06-09-2019 |
| WO 2019094242 A1 | 16-05-2019 | CN 111542624 A | 14-08-2020 |
| | | EP 3707285 A1 | 16-09-2020 |
| | | EP 4299238 A2 | 03-01-2024 |
| | | HU E065228 T2 | 28-05-2024 |
| | | JP 2021502259 A | 28-01-2021 |
| | | KR 20200089273 A | 24-07-2020 |
| | | SG 11202004067U A | 28-05-2020 |
| | | TW 201923103 A | 16-06-2019 |
| | | US 2019134758 A1 | 09-05-2019 |
| | | WO 2019094242 A1 | 16-05-2019 |
| CN 112475664 A | 12-03-2021 | NONE | |
| EP 3988239 A1 | 27-04-2022 | BR 112022001982 A2 | 19-04-2022 |
| | | CN 114245765 A | 25-03-2022 |
| | | EP 3988239 A1 | 27-04-2022 |
| | | JP 6700568 B1 | 27-05-2020 |
| | | JP 2021028078 A | 25-02-2021 |
| | | KR 20220025110 A | 03-03-2022 |
| | | MY 198847 A | 02-10-2023 |
| | | PH 12022550302 A1 | 19-12-2022 |
| | | TW 202106891 A | 16-02-2021 |
| | | TW 202140808 A | 01-11-2021 |
| | | US 2022324061 A1 | 13-10-2022 |
| | | US 2025276412 A1 | 04-09-2025 |
| | | WO 2021029222 A1 | 18-02-2021 |
| EP 3040152 A1 | 06-07-2016 | CN 105189027 A | 23-12-2015 |
| | | EP 3040152 A1 | 06-07-2016 |
| | | ES 2881222 T3 | 29-11-2021 |
| | | JP 6145164 B2 | 07-06-2017 |
| | | JP 2016040051 A | 24-03-2016 |
| | | JP WO2015037279 A1 | 02-03-2017 |
| | | KR 20160053838 A | 13-05-2016 |
| | | SG 11201601920T A | 28-04-2016 |
| | | TW 201521935 A | 16-06-2015 |
| | | US 2016214212 A1 | 28-07-2016 |
| | | WO 2015037279 A1 | 19-03-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5024380 B
- JP 5349703 B
- JP 2016026879 A